# EUROPEAN PATENT SPECIFICATION

(11) **EP 1 582 990 B1**
(45) Date of publication and mention of the grant of the patent: **14.05.2008**
(21) Application number: 05102431.3
(22) Date of filing: 25.03.2005
(51) Int. Cl.: G06F 13/40, G06F 1/18

(54) **Connection system for communication channels and expansion card for electronic apparatus adopting said connection system**
Verbindungssystem für Kommunikationskanäle und mit diesem System ausgerüstete Erweiterungskarte
Système de connexion pour cannaux de communication et carte d' êxtension pour appareil électronique équipé d' un tel systéme

(30) Priority: 29.03.2004 IT UD20040058
(43) Date of publication of application: 05.10.2005
(73) Proprietor: EUROTECH SpA, 33020 Amaro (UD) (IT)
(72) Inventor: Rossi, Mauro, 33013, GEMONA DEL FRIULI (UD) (IT); Tecchiolli, Giampietro, 38100, TRENTO (IT)
(74) Representative: Petraz, Davide Luigi

(56) References cited:
- US-A- 5 628 637
- US-A- 5 903 439
- US-A1- 2002 188 654
- US-B1- 6 599 134

## Description

### FIELD OF THE INVENTION

The present invention concerns a connection system for communication channels. To be more exact, the invention concerns a connection system that can be implemented on an expansion card for electronic apparatuses, which is suitable for the physical management of a plurality of input/output channels connected to a communication node in a network for the transmission of signals between a plurality of electronic apparatuses. The invention is applied in particular, but not exclusively, in high performance computing (HPC) applications, for example parallel computing, where it is necessary to manage a large number of signals traveling at high speed.

US-A-5.628.637 discloses the features of the preamble of the main claim.

### BACKGROUND OF THE INVENTION

Applications in High Performance Computing not only need a large number of processors, but also an efficient communication network between the computer nodes. This allows the information processed by one processor to reach quickly the other nodes concerned, present on the grid.

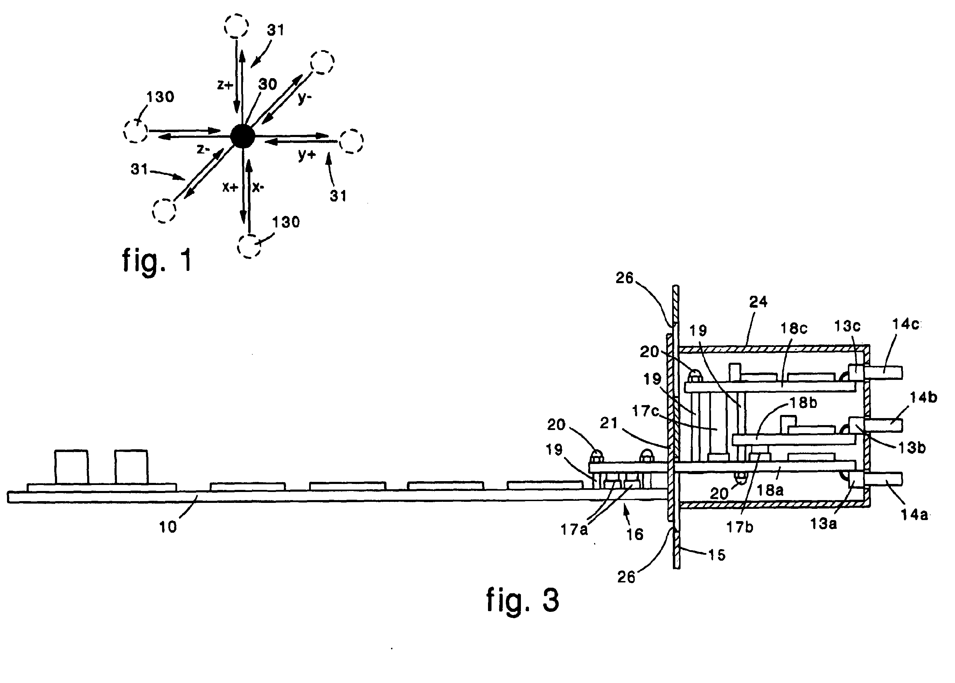

In more complex cases, the grid of processors is of the three-dimensional (3D) type (fig. 1). In 3D type applications, the computer node often includes communication channels which connect it to the six contiguous nodes; each of these in turn interfaces with its six first nearby nodes, and so on. In this way the 3D grid is generated which is usually obtained physically by using a plurality of connectors and cables.

It is therefore obvious that, in these cases, each node 30 must have six independent communication channels 31, two for each of the three fundamental directions x, y, z, that is, x+, x-, y+, y-, z+, z-, as shown as an example in fig. 1.

There may be a further complication of the structure if the link that constitutes the channel is not of the bidirectional type but there is a need to provide two different independent links for the data traveling from one processor to the other, in one direction or the other: this entails the need to manage twelve independent links for every node (two for each of the six communication channels, one to manage input and one to manage output).

It is also obvious that, in parallel computing applications, for example, the input/output channels (I/O) mentioned above have to allow the transfer of the highest possible quantity of information referred to the unit of time (through-put). In obtaining this, a decisive role is played by the number of data traveling in parallel on the individual link (width expressed in bits) and their speed (frequency).

From the physical point of view, preparing the channels and links mentioned above on a computing node means managing on the node a considerable number of connectors and cables. This entails a considerable increase in the bulk of the node, which however conflicts with the trend to increase the density of the computing nodes on systems.

The purpose of the invention is therefore to adopt a system suitable for the physical management of a large number of input/output channels relating and/or connected to a communication node without increasing in a detrimental manner the physical bulk of the node and respecting the constraints of size imposed by current standards.

To be more exact, the purpose of the invention is to find the optimum compromise between the two contrasting requirements of maximizing the transfer of information between adjacent computing nodes (great width of the data link and high transmission frequency), and at the same time minimizing the bulk associated with managing each link (and hence the node).

Applicant has devised, tested and embodied the present invention to overcome these shortcomings of the state of the art and to obtain other advantages.

### SUMMARY OF THE INVENTION

The present invention is set forth and characterized in the main claims, while the dependent claims describe other innovative characteristics of the invention.

A connection system for communication channels according to the invention is advantageously implemented on an expansion card for electronic apparatuses such as a personal computer, a PC-cluster or suchlike.

According to a characteristic of the invention, the expansion card has at least an area where there are means suitable to assemble at least a first additional printed circuit, on which first connection means are located for the connection to said electronic apparatus of at least a first pair of high capacity communication channels (through-put).

In the preferential embodiment of the invention, said first additional printed circuit develops, for a substantial part thereof, outside the frame of the electronic apparatus, for example a chassis able to house expansion card according to the PCI standard.

According to the invention, in turn, on said first additional printed circuit there are means suitable to assemble at least a second additional printed circuit, on which at least second connection means are located for the connection to said electronic apparatus of at least a second pair of communication channels. The second additional printed circuit advantageously develops completely outside said chassis.

In this way, the ability of the electronic apparatus to connect to a greater number of communication channels of equally high capacity (through-put) is increased, and in any case the constraints of size imposed by the standard itself are avoided and in this way the level of freedom in the physical management of the I/O channels is increased.

In fact, the presence of the first and second additional printed circuit assembled on the expansion card, which are mainly arranged outside the chassis of the electronic apparatus, does not create inside the chassis any occupation of space, nor interferences that might impede, for example, access to the connectors (slots on the mother card) adjacent to the connector where the card that manages the communication channels is inserted.

According to an evolutionary and advantageous variant of the invention, said first and/or said second printed circuit also have at least an area in which there are means suitable to assemble at least a third additional printed circuit, on which third connection means are located for the connection to said electronic apparatus of at least a third pair of communication channels.

This third printed circuit too develops outside the chassis of the electronic apparatus, so that the connection capacity to the communication channels is further increased without infringing rules and constraints of size inside the chassis, for example designed to house PCI expansion cards.

In this way we obtain a connection system of a modular type, which can be extended according to requirements, and which allows to manage a large number of high capacity (through-put) communication channels, for example as many as six (with twelve independent links) in the case of three additional printed circuits connected to the expansion card, without creating particular problems or constraints of size since the auxiliary connection part develops almost totally outside the chassis of the electronic apparatus.

The system with 6 channels (12 links) thus structured inhibits to the utmost the direct access to the I/O window of the chassis contiguous to the window associated with the slot where the expansion card is located.

According to an advantageous form of embodiment, the connection system according to the invention provides at least a protective cover, able to be attached outside the chassis of the electronic apparatus, the function of which is to cover and protect the connection part which develops outside said chassis. The attachment of the cover can be facilitated, in some applications, by a front piece coupled with the main expansion card and equipped, for example, with suitable threaded holes to assemble said cover.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a diagram of a computing/communication node connected to six adjacent nodes by means of respective communication channels in a three-dimensional communication network;
- fig. 2 shows a perspective view of an expansion card which implements the connection system according to the invention assembled on a mother card of an electronic apparatus;
- fig. 3 is a lateral view of an expansion card according to the invention.

### DETAILED DESCRIPTION OF A PREFERENTIAL FORM OF EMBODIMENT OF THE INVENTION

With reference to the attached figures, fig. 1 shows schematically a computing/communication node, indicated in its entirety by the reference number 30, in a three-dimensional grid. The node 30 can be connected to six adjacent nodes 130 (shown by dashes in the figure) by means of relative communication channels, indicated in general by the reference number 31. The computing/communication node 30 can, for example, be referred to a processor employed in a network of processors for high performance computing (HPC) applications, for example for parallel computing.

The computing/communication node 30 is implemented, in this case, in a PCI standard expansion card 10 (for example PCI-X, 133MHz, 64bit), able to manage 6 communication channels (x+, x-, y+, y-, z+, z-), with 2 independent links for every communication channel (one for input, one for output).

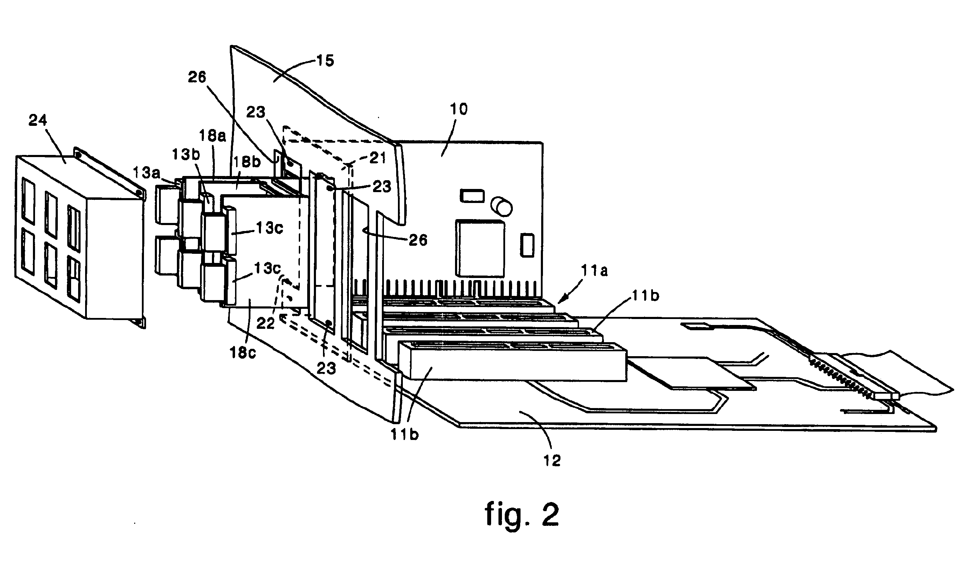

The expansion card 10 (fig. 2) can be inserted into a relative female connector 11a of a mother card 12 of an electronic apparatus, not shown in greater detail except for a part of the chassis 15, partly schematic. The mother card 12 has a plurality of other female connectors 11b, adjacent to the connector 11a, for the insertion of possible other expansion cards used for other functions. In correspondence with each of the female connectors 11a, 11b (slots) there is a relative I/O window or slit 26 on the chassis 15.

The physical structure of the connection provides to use six card-to-cable connectors, respectively a first pair 13a, a second pair 13b and a third pair 13c, corresponding to six cables 14, one for each of the communication channels (x+, x-, y+, y-, z+, z-), wherein each connector, and hence each cable, incorporates the two independent links involved in the communication channel pertaining to said connector. By suitably designing the printed circuits and by suitably choosing the connectors, the structure as described heretofore allows to obtain an overall data transfer capacity which can reach several Gbyte/sec (for example, 9.6 Gbyte/sec).

The connection system according to the invention is implemented on the expansion card 10 to obtain the following requirements:
- to guarantee compatibility with chassis able to house standard PCI expansion cards 10;
- not to use or inhibit access to other slots 11b of the mother card 12 which is not the slot (11a) wherein the expansion card 10 in question is inserted;
- not to inhibit access to more than one I/O PCI window 26 of the chassis apart from the window pertaining to the expansion card 10 in question.

A further requirement to be satisfied is to re-direct the weight of the cables, when they are inserted, and possible mechanical stresses associated with their management towards the chassis 15, instead of towards the printed circuits, and also to provide a pleasing aesthetic appearance to the system by masking and protecting all the outer parts directly involved in the I/O management.

In order to obtain these requirements, the expansion card 10 has (fig. 3) an area 16 wherein there is at least a connector 17a of the card-to-card type suitable to assemble a first printed circuit 18a. The first printed circuit 18a develops mainly outside the chassis 15 of the electronic apparatus and has first connectors 13a, and relative cables 14a, to equip said electronic apparatus with a first pair of communication channels 31.

In turn, on said first printed circuit 18a there is a second connector 17b and a third connector 17c, of the card-to-card type, to assemble respectively a second printed circuit 18b and a third printed circuit 18c, which have mating card-to-card connectors, not shown in detail, which couple with the aforesaid connectors 17b and 17c.

The second printed circuit 18b supports second connectors 13b and relative cables 14b, while the third printed circuit 18c supports third connectors 13c and relative cables 14c, in order to arrange respectively a second and a third pair of communication channels 31 on said electronic apparatus.

Both the first 18a and the second 18b and the third 18c printed circuit are arranged mainly outside the chassis 15 of the electronic apparatus. Consequently, they do not occupy any space nor create any interference that can impede the insertion of other expansion cards into the connectors 11b (slots) adjacent to the connector 11a in which the card 10 which manages the communication channels is inserted.

The system thus described not only guarantees the management of a large number of high capacity communication channels (through-put) respecting the constraints of size imposed by standards, but also ensures great flexibility and variability of the configuration. In fact, it can be configured with quick and easy assembly/disassembly operations, for the physical management of different input/output channels such as the one-dimensional grid, which requires only two connectors (or a single additional printed circuit 18a), the bidimensional grid, which requires four connectors (or two additional printed circuits 18a and 18b), and others.

In order to reinforce the structure and strengthen the anchorage of the parts, the system provides to use spacer columns 19 and screws 20 between the various printed circuits 18a, 18b and 18c.

Moreover, the system provides that, should the applications make it necessary, there is a front piece 21 (indicated with a line of dots and dashes in fig. 2) on the main card 10. The front piece 21 is provided with a slit 22 which allows the extension of the expansion card 10 outside the chassis 15 by means of the additional printed circuit 18a, and four threaded holes 23 which allow the coupling of the front piece 21 and an outer metal cover 24. The function of the metal cover 24 is to cover and protect the I/O management part of the expansion card 10 that develops outside the chassis 15, and includes a plurality of slits 25 through which the connectors 13a, 13b, 13c can exist therefrom, in order to allow the relative cables 14a, 14b, 14c to be assembled.

## Claims

1. An expansion card and a connection system with at least a first printed circuit (18a) and a second printed circuit (18b) for connecting a plurality of communication channels (31) to an electronic apparatus such as a personal computer, a PC-cluster or such like, wherein said expansion card (10) is able to be associated with a mother card connector (11a) of the electronic apparatus, wherein said expansion card (10) includes an area (16) for a connector (17a) of the card-to-card type suitable to assemble said first printed circuit (18a), wherein said first printed circuit (18a) supports first connectors (13a) and relative cables (14a), to equip said electronic apparatus with a first pair of communication channels (31), wherein said first printed circuit (18a) includes thereon a second connector (17b) of the card-to-card type, to assemble the second printed circuit (18b), wherein the second printed circuit (18b) supports second connectors (13b) and relative cables (14b), to equip said electronic apparatus with a second pair of communication channels (31),
**characterized in that**
said first printed circuit (18a) and said second printed circuit (18b) develop partly outside the chassis (15) of said electronic apparatus, in a manner that the presence of the first and second additional printed circuit assembled on said expansion card (10) does not create inside said chassis (15) any occupation of space, nor interferences that might impede access to the mother card connectors adjacent to the connector where the card that manages said communication channels (31) is inserted.

2. An expansion card and a connection system as in claim 1, **characterized in that** said first (18a) and/or said second (18b) printed circuit include a third connector (17c) for assembling at least a third printed circuit (18c) supporting third connectors (13b) for managing a third pair of communication channels (31) on said electronic apparatus, wherein said third printed circuit (18c) develop outside said chassis (15).

3. An expansion card and a connection system as in claim 1 or 2, **characterized in that** it comprises a protective cover (24) able to be applied on the outside of said chassis (15) in order to cover and protect the structure generated by the superimposition of said printed circuits (18a, 18b, 18c).

4. An expansion card and a connection system as in claim 3, **characterized in that** it comprises a front piece (21) able to be applied on the outside of said chassis and including means (23) to attach said protective cover (24).

5. An expansion card and a connection system as in any claim hereinbefore, **characterized in that** it comprises a plurality of columns (19) located between said printed circuits (18a, 18b, 18c) and having a stiffening and spacing function.

6. An expansion card and a connection system as in any claim hereinbefore, **characterized in that** it has an overall size, for the part inside said chassis (15), able to allow, in its assembled condition on said relative connector (11a) of said mother card (12), free access to the connectors (11b) adjacent to said connector (11a).

## Patentansprüche

1. Erweiterungskarte und Verbindungssystem mit zumindest einer ersten gedruckten Schaltung (18a) und einer zweiten gedruckten Schaltung (18b) zum Verbinden einer Mehrzahl von Kommunikationskanälen (31) mit einer elektronischen Vorrichtung wie beispielsweise einem Personalcomputer, einem PC-Cluster oder dergleichen, wobei die Erweiterungskarte (10) mit einem Hauptkartenverbinder (11a) der elektronischen Vorrichtung verbunden werden kann, wobei die Erweiterungskarte (10) einen Bereich (16) für einen Verbinder (17a) des Karte-zu-Karte-Typs umfasst, geeignet, um die erste gedruckte Schaltung (18a) zusammenzubauen, wobei die erste gedruckte Schaltung (18a) erste Verbinder (13a) und relative Kabel (14a) trägt, um die elektronische Vorrichtung mit einem ersten Paar von Kommunikationskanälen (31) auszustatten, wobei die erste gedruckte Schaltung (18a) darauf einen zweiten Verbinder (17b) des Karte-zu-Karte-Typs umfasst, um die zweite gedruckte Schaltung (18b) zusammenzubauen, wobei die zweite gedruckte Schaltung (18b) zweite Verbinder (13b) und relative Kabel (14b) trägt, um die elektronische Vorrichtung mit einem zweiten Paar von Kommunikationskanälen (31) auszustatten,
**dadurch gekennzeichnet, dass**
die erste gedruckte Schaltung (18a) und die zweite gedruckte Schaltung (18b) sich teilweise außerhalb des Chassis (15) der elektronischen Vorrichtung zeigen, in einer Weise, dass das Vorhandensein der ersten und zweiten zusätzlichen gedruckten Schaltung, zusammengebaut auf der Erweiterungskarte (10), innerhalb des Chassis (15) keine Besetzung von Raum oder Behinderungen erzeugt, die einen Zugang zu den Hauptkartenverbindern benachbart zum Verbinder, wo die Karte eingeführt wird, die die Kommunikationskanäle (31) verwaltet, behindern könnten.

2. Erweiterungskarte und Verbindungssystem nach Anspruch 1, **dadurch gekennzeichnet, dass** die erste (18a) und/oder die zweite (18b) gedruckte Schaltung einen dritten Verbinder (17c) zum Zusammenbauen von zumindest einer dritten gedruckten Schaltung (18c), tragend dritte Verbinder (13b) zum Verwalten eines dritten Paares von Kommunikationskanälen (31) auf der elektronischen Vorrichtung, umfasst, wobei die dritte gedruckte Schaltung (18c) sich außerhalb des Chassis (15) zeigt.

3. Erweiterungskarte und Verbindungssystem nach Anspruch 1 oder 2, **dadurch gekennzeichnet, dass** sie eine Schutzabdeckung (24) umfasst, die auf der Außenseite des Chassis (15) aufgebracht werden kann, um die durch die Übereinanderlagerung der gedruckten Schaltungen (18a, 18b, 18c) erzeugte Struktur zu bedecken und zu schützen.

4. Erweiterungskarte und Verbindungssystem nach Anspruch 3, **dadurch gekennzeichnet, dass** sie ein Vorderstück (21) umfasst, das auf der Außenseite des Chassis (15) aufgebracht werden kann, und umfassend Mittel (23) zum Befestigen der Schutzabdeckung (24).

5. Erweiterungskarte und Verbindungssystem nach einem der vorherigen Ansprüche, **dadurch gekennzeichnet, dass** sie eine Mehrzahl von Stützen (19) umfasst, angeordnet zwischen den gedruckten Schaltungen (18a, 18b, 18c) und eine Versteifungs- und Beabstandungsfunktion aufweisend.

6. Erweiterungskarte und Verbindungssystem nach einem der vorherigen Ansprüche, **dadurch gekennzeichnet, dass** sie eine Gesamtgröße, für den Teil innerhalb des Chassis (15), aufweist, die es ermöglicht, in ihrem zusammengebauten Zustand auf dem entsprechenden Verbinder (11a) der Hauptkarte (12), einen freien Zugang zu den Verbindern (11b) benachbart zum Verbinder (11a) zu erlauben.

## Revendications

1. Système de connexion et carte d'extension comprenant au moins un premier circuit imprimé (18a) et un deuxième circuit imprimé (18b) pour connecter une pluralité de canaux de communication (31) à un appareil électronique comme, par exemple, un ordinateur personnel, un groupe de PC, ou similaire, dans lequel ladite carte d'extension (10) est apte à être associé à un connecteur de carte mère (11a) de l'appareil électronique, dans lequel ladite carte d'extension (10) comprend une zone (16) pour un connecteur (17a) du type de carte à carte qui est adapté pour assembler ledit premier circuit imprimé (18a), dans lequel ledit premier circuit imprimé (18a) prend en charge des premiers connecteurs (13a) et des câbles associés (14a), pour équiper ledit appareil électronique avec une première paire de canaux de communication (31), dans lequel ledit premier circuit imprimé (18a) comprend sur lui un deuxième connecteur (17b) du type de carte à carte, qui est adapté pour assembler le deuxième circuit imprimé (18b), dans lequel le deuxième circuit imprimé (18b) prend en charge des deuxièmes connecteurs (13b) et des câbles associés (14b), pour équiper ledit appareil électronique avec une deuxième paire de canaux de communication (31),
**caractérisé en ce que** ledit premier circuit imprimé (18a) et ledit deuxième circuit imprimé (18b) se développent partiellement à l'extérieur du châssis (15) dudit appareil électronique, de telle manière que la présence du premier et du deuxième circuits imprimés supplémentaires assemblés sur ladite carte d'extension (10) ne crée, à l'intérieur dudit châssis (15), ni occupation de place ni interférence qui pourrait gêner un accès aux connecteurs de carte mère qui sont adjacents au connecteur où la carte qui gère lesdits canaux de communication (31) est insérée.

2. Système de connexion et carte d'extension selon la revendication 1, **caractérisé en ce que** ledit premier (18a) et / ou ledit deuxième (18b) circuits imprimés comprennent un troisième connecteur (17c) pour assembler au moins un troisième circuit imprimé (18c) qui prend en charge des troisièmes connecteurs (13b) pour gérer une troisième paire de canaux de communication (31) sur ledit appareil électronique, dans lequel ledit troisième circuit imprimé (18c) se développe à l'extérieur dudit châssis (15).

3. Système de connexion et carte d'extension selon la revendication 1 ou 2, **caractérisé en ce qu'**il comprend un couvercle de protection (24) qui est apte à être appliqué sur l'extérieur dudit châssis (15) dans le but de couvrir et de protéger la structure générée par la superposition desdits circuits imprimés (18a, 18b, 18c).

4. Système de connexion et carte d'extension selon la revendication 3, **caractérisé en ce qu'**il comprend une partie frontale (21) qui est apte à être appliquée sur l'extérieur dudit châssis (15) et qui comprend des moyens (23) pour fixer ledit couvercle de protection (24).

5. Système de connexion et carte d'extension selon l'une quelconque des revendications précédentes, **caractérisé en ce qu'**il comprend une pluralité de colonnes (19) localisées entre lesdits circuits imprimés (18a, 18b, 18c) et ayant une fonction de raidissement et d'espacement.

6. Système de connexion et carte d'extension selon l'une quelconque des revendications précédentes, **caractérisé en ce qu'**il a une dimension globale, pour la partie à l'intérieur dudit châssis (15), qui est apte à permettre, dans son état assemblé sur ledit connecteur associé (11a) de ladite carte mère (12), un accès libre aux connecteurs (11b) adjacents audit connecteur (11a).
